# EUROPEAN PATENT APPLICATION

(11) **EP 4 847 934 A2**
(43) Date of publication of application: **02.12.2026**
(21) Application number: 26197046.1
(22) Date of filing: 06.08.2026
(51) Int. Cl.: G01R 31/67

(54) **DETECTION METHOD FOR CROSS MISCONNECTION OF PHOTOVOLTAIC CONNECTION TERMINALS, APPARATUS, AND ELECTRONIC DEVICE**

(30) Priority: 23.10.2025 CN 202511519643
(71) Applicant: Shenzhen Hello Tech Energy Co., Ltd, Shenzhen, Guangdong 518109 (CN)
(72) Inventor: YANG, Jian, Guangdong, 518109 (CN); HUANG, Wenjun, Guangdong, 518109 (CN); DENG, Zhixian, Guangdong, 518109 (CN); PEI, Jianing, Guangdong, 518109 (CN); LIANG, Yuehui, Guangdong, 518109 (CN)
(74) Representative: Zacco Norway AS

(57) **Abstract**

Provided are a detection method for cross-misconnection of photovoltaic connection terminals, an apparatus and an electronic device. The method includes: acquiring a first converted inductor current and a first sampled inductor current; acquiring a second converted inductor current and a second sampled inductor current; and determining that a photovoltaic panel negative terminal cross-misconnection exists in response to determining that an absolute value of a difference between the first converted inductor current and the first sampled inductor current is greater than a first predetermined threshold and an absolute value of a difference between the second converted inductor current and the first sampled inductor current is less than a second predetermined threshold. The photovoltaic panel negative terminal cross-misconnection means that a first panel negative terminal is erroneously connected to a second photovoltaic negative device terminal, and a second panel negative terminal is erroneously connected to a first photovoltaic negative device terminal.

## Description

### FIELD

The present disclosure relates to the field of energy storage system technologies, and more particularly, to a detection method for cross-misconnection of photovoltaic connection terminals, an apparatus and an electronic device.

### BACKGROUND

A photovoltaic energy storage system is an integrated system composed of a photovoltaic module and an energy storage device. A core function of the photovoltaic energy storage system is to capture solar energy through the photovoltaic module and convert the solar energy into electric energy, store the electric energy in the energy storage device, and supply power to some loads through the energy storage device based on power consumption demands, thus achieving efficient energy utilization and balance between energy supply and demand.

In general, all photovoltaic input interfaces (photovoltaic connection terminals) adopt the same configuration. Thus, cross-misconnection between two or more photovoltaic connection terminals tends to exist during mounting. As cross-misconnection of photovoltaic connection terminals does not affect normal operation, staff and users may overlook a cross-misconnection issue.

The cross-misconnection may cause incorrect collection of a photovoltaic input current, affecting a maximum power point tracking function of a photovoltaic system, and further affecting energy utilization efficiency. In addition, the cross-misconnection may lead to mutual coupling between photovoltaic DC converters, affecting stable operation of the photovoltaic DC converters.

To address the cross-misconnection issue of the photovoltaic connection terminals, an existing solution is to rely on manual inspection and verification by staff or the users during mounting of the photovoltaic module. However, due to the similarity of the photovoltaic modules, cables, and wiring terminals, and complexity of the on-site environment, such inspections are prone to missed detection.

Therefore, how to provide a detection method or a detection apparatus for cross-misconnection of photovoltaic connection terminals is an urgent problem to be solved.

### SUMMARY

In order to solve or improve a technical problem that manual inspection is prone to missed detection and cannot accurately and efficiently detect cross-misconnection of photovoltaic connection terminals, an objective of the present disclosure is to provide a detection method for cross-misconnection of photovoltaic connection terminals.

Another objective of the present disclosure is to provide a detection apparatus for cross-misconnection of photovoltaic connection terminals.

Another objective of the present disclosure is to provide an electronic device.

To achieve the above objectives, a first aspect of the present disclosure provides a detection method for cross-misconnection of photovoltaic connection terminals. The detection method is applied to an energy storage device. The energy storage device includes a first photovoltaic direct current (DC) converter and a second photovoltaic DC converter. The first photovoltaic DC converter is provided with a first photovoltaic positive device terminal and a first photovoltaic negative device terminal, and includes a first buck-boost inductor, the first photovoltaic positive device terminal being configured to be connected to a first panel positive terminal of a first photovoltaic panel. The second photovoltaic DC converter is provided with a second photovoltaic positive device terminal and a second photovoltaic negative device terminal, and includes a second buck-boost inductor, the second photovoltaic positive device terminal being configured to be connected to a second panel positive terminal of a second photovoltaic panel.

The detection method includes: acquiring a first converted inductor current and a first sampled inductor current, where the first converted inductor current is converted from a first input current of the first photovoltaic negative device terminal based on a first conversion relation, and the first sampled inductor current is an average current of the first buck-boost inductor within a sampling period; acquiring a second converted inductor current and a second sampled inductor current, where the second converted inductor current is converted from a second input current of the second photovoltaic negative device terminal based on the first conversion relation, and the second sampled inductor current is an average current of the second buck-boost inductor within the sampling period; and determining that a photovoltaic panel negative terminal cross-misconnection exists in response to determining that an absolute value of a difference between the first converted inductor current and the first sampled inductor current is greater than a first predetermined threshold and an absolute value of a difference between the second converted inductor current and the first sampled inductor current is less than a second predetermined threshold, where the photovoltaic panel negative terminal cross-misconnection means that a first panel negative terminal of the first photovoltaic panel is erroneously connected to the second photovoltaic negative device terminal, and a second panel negative terminal of the second photovoltaic panel is erroneously connected to the first photovoltaic negative device terminal.

The present disclosure aims to provide a detection method for cross-misconnection of photovoltaic connection terminals. Based on the first sampled inductor current, the first converted inductor current, and the second converted inductor current, it is determined whether the photovoltaic panel negative terminal cross-misconnection exists. With this detection method, firstly, existence and position of the photovoltaic panel negative terminal cross-misconnection can be determined timely and accurately, which is conductive to reducing labor intensity and a likelihood of missed detection, improving detection efficiency and accuracy of a detection result. Secondly, the cross-misconnection of the photovoltaic connection terminals can be effectively detected without increasing a hardware cost, facilitating control of a detection cost. Thirdly, through accurate and efficient detection of the cross-misconnection of the photovoltaic connection terminals, a significant deviation in collection of a photovoltaic input current can be effectively avoided, ensuring that the maximum power point tracking function of the photovoltaic system does not fail, and enabling the photovoltaic panel to operate at an optimal power generation efficiency point, thereby facilitating the improvement of solar energy utilization efficiency. Also, unintended electrical coupling between the photovoltaic DC converters can be effectively prevented, which is conducive to prolonging a service life of relevant electronic components, ensuring long-term stable operation of the energy storage device.

In some technical solutions, the detection method further includes, subsequent to said determining that the photovoltaic panel negative terminal cross-misconnection exists: transmitting cross-misconnection fault information to an energy storage management cloud platform, to enable the energy storage management cloud platform to transmit cross-misconnection prompt information to a user terminal based on the cross-misconnection fault information; or transmitting the cross-misconnection fault information to the user terminal through short-range wireless communication.

In this technical solution, a fault position is identified timely, and staff or users are reminded or notified to inspect wiring. This design helps reduce the labor intensity and the likelihood of missed detection, improving the detection efficiency and the accuracy of the detection result.

In some technical solutions, the energy storage device further includes a first indicator light and a second indicator light. The first indicator light is disposed at the first photovoltaic negative device terminal, and the second indicator light is disposed at the second photovoltaic negative device terminal. the detection method further includes, subsequent to said determining that the photovoltaic panel negative terminal cross-misconnection exists: controlling the first indicator light and the second indicator light to light up or flash.

In this technical solution, by providing the indicator lights, it is convenient for the staff or the users to timely and accurately determine the existence and position of the photovoltaic panel negative terminal cross-misconnection, which is conducive to reducing the labor intensity and the likelihood of missed detection.

In some technical solutions, the energy storage device further includes a voice prompt module. The detection method further includes, subsequent to said determining that the photovoltaic panel negative terminal cross-misconnection exists: controlling the voice prompt module to broadcast cross-misconnection fault information.

In this technical solution, by providing the voice prompt module, it is convenient for the staff or the users to timely and accurately determine the existence and position of the photovoltaic panel negative terminal cross-misconnection, which is conducive to reducing the labor intensity and the likelihood of missed detection.

In some technical solutions, the energy storage device further includes a battery module. Each of an output end of the first photovoltaic DC converter and an output end of the second photovoltaic DC converter is connected to the battery module. The detection method further includes: acquiring a first photovoltaic input voltage at an input end of the first photovoltaic DC converter, and a battery voltage of the battery module connected to the output end of the first photovoltaic DC converter; determining a first bridge arm duty cycle of a bridge arm of the first photovoltaic DC converter that is adjacent to the first photovoltaic panel based on a ratio of the battery voltage to the first photovoltaic input voltage; and determining the first conversion relation based on the first bridge arm duty cycle.

In this technical solution, the first bridge arm duty cycle is determined based on the ratio of the battery voltage to the first photovoltaic input voltage, and the first conversion relation is determined, so that in subsequent operations, the first converted inductor current is determined based on the first input current and the first conversion relation, and the second converted inductor current is determined based on the second input current and the first conversion relation.

In some technical solutions, said determining that the photovoltaic panel negative terminal cross-misconnection exists in response to determining that the absolute value of the difference between the first converted inductor current and the first sampled inductor current is greater than the first predetermined threshold and the absolute value of the difference between the second converted inductor current and the first sampled inductor current is less than the second predetermined threshold includes: within a predetermined time duration, continuously acquiring the first converted inductor current and the first sampled inductor current, and continuously acquiring the second converted inductor current and the second sampled inductor; and determining that the photovoltaic panel negative terminal cross-misconnection exists in response to determining that the absolute value of the difference between the first converted inductor current and the first sampled inductor current remains greater than the first predetermined threshold throughout the predetermined time duration and the absolute value of the difference between the second converted inductor current and the first sampled inductor current remains less than the second predetermined threshold throughout the predetermined time duration.

In this technical solution, on the basis of two determination conditions, a limitation that "a time duration during which the two determination conditions are satisfied is greater than or equal to a predetermined time duration" is added to form a composite detection logic of " dual difference determination and time verification". This detection method can filter out a short-duration interference signal, which is conducive to improving the accuracy of the detection result, avoiding misjudgment to a great extent.

In some technical solutions, the first predetermined threshold ranges from 1 A to 3 A; and/or the second predetermined threshold ranges from 1 A to 3 A; and/or the predetermined time duration ranges from 1 s to 3 s.

In this technical solution, a value range of the predetermined threshold (the first predetermined threshold or the second predetermined threshold) is defined. Firstly, an excessively small predetermined threshold is avoided, so that numerical sampling and numerical calculation (conversion) can effectively tolerate inherent errors in numerical sampling and current conversion processes of the photovoltaic energy storage system within a certain error range. Secondly, an excessively large predetermined threshold is avoided, which helps ensure detection sensitivity, thus accurately detecting whether there is a photovoltaic cross-connection error.

A value range of the predetermined time duration is defined. Firstly, an excessively short predetermined time duration is avoided to ensure that the short-duration interference signal can be filtered out, thus improving the accuracy of the detection result. Secondly, an excessively long predetermined time duration is avoided, which is conducive to improving the detection efficiency.

In some technical solutions, a plurality of second photovoltaic DC converters are provided and a plurality of second photovoltaic panels are provided, the second photovoltaic positive device terminal of each of the plurality of second photovoltaic DC converters being configured to be connected to the second panel positive terminal of a corresponding one of the plurality of second photovoltaic panels. Said acquiring the second converted inductor current and the second sampled inductor current includes: for each of the plurality of second photovoltaic DC converters, acquiring the second converted inductor current and the second sampled inductor current corresponding to the second photovoltaic DC converter. Said determining that the photovoltaic panel negative terminal cross-misconnection exists in response to determining that the absolute value of the difference between the first converted inductor current and the first sampled inductor current is greater than the first predetermined threshold, and the absolute value of the difference between the second converted inductor current and the first sampled inductor current is less than the second predetermined threshold includes: taking each of the plurality of second photovoltaic DC converters as a current second photovoltaic DC converter in sequence; and in response to determining that the absolute value of the difference between the first converted inductor current and the first sampled inductor current is greater than the first predetermined threshold and an absolute value of a difference between the second converted inductor current corresponding to the current second photovoltaic DC converter and the first sampled inductor current is less than the second predetermined threshold, determining that the photovoltaic panel negative terminal cross-misconnection exists between the first photovoltaic DC converter and the current second photovoltaic DC converter.

In this technical solution, the first converted inductor current is compared with the first sampled inductor current to determine whether the cross-misconnection exists. Each second converted inductor current is compared with the first sampled inductor current to determine whether the cross-misconnection exists and locate a position of such cross-misconnection. With this design, when the cross-misconnection exists, it is convenient for the staff or the users to timely and accurately determine the existence and position of the photovoltaic panel negative terminal cross-misconnection, which is conducive to reducing the labor intensity and the likelihood of missed detection.

A second aspect of the present disclosure provides a detection apparatus for cross-misconnection of photovoltaic connection terminals. The detection apparatus includes: a first current acquisition unit configured to acquire a first converted inductor current and a first sampled inductor current, where the first converted inductor current is converted from a first input current of a first photovoltaic negative device terminal based on a first conversion relation, and the first sampled inductor current is an average current of a first buck-boost inductor within a sampling period; a second current acquisition unit configured to acquire a second converted inductor current and a second sampled inductor current, where the second converted inductor current is converted from a second input current of a second photovoltaic negative device terminal based on the first conversion relation, and the second sampled inductor current is an average current of a second buck-boost inductor within the sampling period; and a cross-misconnection determination unit configured to determine that a photovoltaic panel negative terminal cross-misconnection exists in response to determining that an absolute value of a difference between the first converted inductor current and the first sampled inductor current is greater than a first predetermined threshold, and an absolute value of a difference between the second converted inductor current and the first sampled inductor current is less than a second predetermined threshold. The photovoltaic panel negative terminal cross-misconnection means that a first panel negative terminal of a first photovoltaic panel is erroneously connected to the second photovoltaic negative device terminal, and a second panel negative terminal of a second photovoltaic panel is erroneously connected to the first photovoltaic negative device terminal.

The present disclosure aims to provide a detection apparatus for cross-misconnection of photovoltaic connection terminals. Based on the first sampled inductor current, the first converted inductor current, and the second converted inductor current, it is determined that whether the photovoltaic panel negative terminal cross-misconnection exists. With this detection method, firstly, the existence and position of the photovoltaic panel negative terminal cross-misconnection can be determined timely and accurately, which is conductive to reducing the labor intensity and the likelihood of missed detection, improving the detection efficiency and the accuracy of the detection result. Secondly, the cross-misconnection of the photovoltaic connection terminals can be effectively detected without increasing the hardware cost, facilitating control of the detection cost. Thirdly, through the accurate and efficient detection of the cross-misconnection of the photovoltaic connection terminals, the significant deviation in collection of the photovoltaic input current can be effectively avoided, ensuring that the maximum power point tracking function of the photovoltaic system does not fail, and enabling the photovoltaic panel to operate at the optimal power generation efficiency point, thereby facilitating the improvement of the solar energy utilization efficiency. Also, unintended electrical coupling between the photovoltaic DC converters can be effectively prevented, which is conducive to prolonging the service life of the relevant electronic components, ensuring the long-term stable operation of the energy storage device.

A third aspect of the present disclosure provides an electronic device. The electronic device includes a memory and a processor. The memory stores a program or an instruction executable by the processor. The program or the instruction, when executed by the processor, causes the processor to implement operations of the detection method for the cross-misconnection of the photovoltaic connection terminals according to any one of the above technical solutions. The electronic device has the beneficial effects of any one of the above technical solutions, which will not be elaborated herein.

Additional aspects and advantages of the technical solutions of the present disclosure will become apparent in part from the following description, or can be learned from practicing of the present disclosure.

### BRIEF DESCRIPTION OF THE DRAWINGS

FIG. 1 is a circuit diagram of a photovoltaic energy storage system according to an embodiment of the present disclosure.
FIG. 2 is a circuit diagram of a photovoltaic energy storage system according to another embodiment of the present disclosure.
FIG. 3 is a structural block diagram of a photovoltaic energy storage system according to an embodiment of the present disclosure.
FIG. 4 is a structural block diagram of a photovoltaic energy storage system according to another embodiment of the present disclosure.
FIG. 5 is a structural block diagram of a photovoltaic energy storage system according to another embodiment of the present disclosure.
FIG. 6 is a structural block diagram of a photovoltaic energy storage system according to another embodiment of the present disclosure.
FIG. 7 is a flowchart of a detection method for cross-misconnection of photovoltaic connection terminals according to an embodiment of the present disclosure.
FIG. 8 is a flowchart of a detection method for cross-misconnection of photovoltaic connection terminals according to another embodiment of the present disclosure.
FIG. 9 is a flowchart of a detection method for cross-misconnection of photovoltaic connection terminals according to another embodiment of the present disclosure.
FIG. 10 is a structural block diagram of an energy storage device according to an embodiment of the present disclosure.
FIG. 11 is a flowchart of a detection method for cross-misconnection of photovoltaic connection terminals according to another embodiment of the present disclosure.
FIG. 12 is a flowchart of a detection method for cross-misconnection of photovoltaic connection terminals according to another embodiment of the present disclosure.
FIG. 13 is a flowchart of a detection method for cross-misconnection of photovoltaic connection terminals according to another embodiment of the present disclosure.
FIG. 14 is a flowchart of a detection method for cross-misconnection of photovoltaic connection terminals according to another embodiment of the present disclosure.
FIG. 15 is a structural block diagram of a detection apparatus for cross-misconnection of photovoltaic connection terminals according to an embodiment of the present disclosure.
FIG. 16 is a structural block diagram of an electronic device according to an embodiment of the present disclosure.

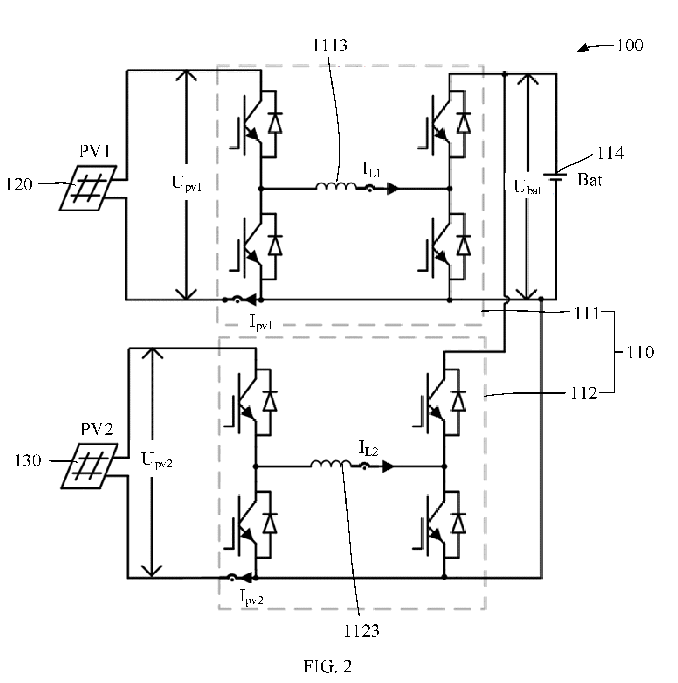

Correspondence between reference numerals and component names in FIG. 1 to FIG. 16 is as follows:
100: photovoltaic energy storage system; 110: energy storage device; 111: first photovoltaic DC converter; 1111: first photovoltaic positive device terminal; 1112: first photovoltaic negative device terminal; 1113: first buck-boost inductor; 112: second photovoltaic DC converter; 1121: second photovoltaic positive device terminal; 1122: second photovoltaic negative device terminal; 1123: second buck-boost inductor; 114: battery module; 1151: first indicator light; 1152: second indicator light; 116: voice prompt module; 120: first photovoltaic panel; 121: first panel positive terminal; 122: first panel negative terminal; 130: second photovoltaic panel; 131: second panel positive terminal; 132: second panel negative terminal; 300: detection apparatus for cross-misconnection of photovoltaic connection terminals; 310: first current acquisition unit; 320: second current acquisition unit; 330: cross-misconnection determination unit; 400: electronic device; 410: memory; 420: processor.

### DETAILED DESCRIPTION OF THE EMBODIMENTS

To more clearly understand the above objectives, features and advantages of the embodiments of the present disclosure, the embodiments of the present disclosure will be further described in detail below in conjunction with the accompanying drawings and specific embodiments. It should be noted that the embodiments and the features thereof in the present disclosure can be combined with each other without conflict.

In the following description, many specific details are provided to facilitate full understanding of the present disclosure. However, the embodiments of the present disclosure can further be implemented in many other ways than those described herein. Therefore, the protection scope of the present disclosure is not limited by specific embodiments disclosed below.

With the global energy structure transitioning toward cleanliness and low carbon, new energy technologies, especially photovoltaic power generation technologies, have achieved rapid development. As core equipment for efficient storage and flexible application of photovoltaic power, photovoltaic energy storage systems are widely deployed in households, industrial and commercial facilities, large-scale power stations and other scenarios.

The photovoltaic energy storage system is an integrated system composed of a photovoltaic module and an energy storage device. A core function of the photovoltaic energy storage system is to capture solar energy through the photovoltaic module and convert the solar energy into electric energy, store the electric energy in the energy storage device, and supply power to some loads through the energy storage device based on power consumption demands, thus achieving efficient energy utilization and balance between energy supply and demand.

In the current mainstream architecture of the photovoltaic energy storage system, to increase a total amount of collected energy, connecting multiple photovoltaic modules in parallel to a single energy storage device has become a commonly adopted design solution in the industry. However, since input interfaces, supporting cables, and wiring terminals of various photovoltaic modules are highly identical in structure and appearance, staff or users may easily cause cross-misconnection of terminals between two or more photovoltaic modules due to visual confusion, operational negligence and other reasons during on-site mounting and construction. Specifically, an output terminal of one photovoltaic module fails to be connected to an input end of a corresponding photovoltaic DC converter as designed, but is erroneously connected to an input end of another photovoltaic DC converter.

The energy storage device, also referred to as an all-in-one energy storage unit, is an integrated device combining an energy storage battery and an inverter. The energy storage device may be a consumer-grade energy storage device, including an outdoor portable energy storage device, a household energy storage device, and a balcony photovoltaic energy storage device. The outdoor portable energy storage device is specially designed for mobile scenarios such as camping and self-driving tours, providing lightweight, plug-and-play power supply with medium and low power ratings. The household energy storage device is intended for users with detached residences (that are generally equipped with rooftop photovoltaic). The household energy storage device is deeply integrated with a photovoltaic system to store surplus power for household energy management (to improve a self-consumption rate) and provide long-duration emergency backup power. The balcony photovoltaic energy storage device is developed for urban apartment users (with limited space and budget). By mounting a miniature photovoltaic module on the balcony and combining the miniature photovoltaic module with a small-scale energy storage unit, a goal of "self-generation for self-use and grid feed of surplus power" can be achieved, which is mainly used to reduce daily electricity costs.

The cross-misconnection will not cause the photovoltaic energy storage system to shut down directly, and the system can still maintain a basic operating state, which makes it difficult to detect and troubleshoot the cross-misconnection immediately after mounting.

Long-term existence of a cross-misconnection issue may lead to two major core technical defects. On the one hand, the cross-misconnection may cause a significant deviation in collection of a photovoltaic input current. Since accuracy of current collection serves as a fundamental basis for the photovoltaic system to realize a maximum power point tracking (MPPT) function, incorrect current collection may directly disable the MPPT function, thus preventing the photovoltaic module from operating at an optimal power generation efficiency point, and greatly reducing utilization efficiency of the solar energy. On the other hand, as a key conversion unit connecting the photovoltaic module and the energy storage device, the photovoltaic DC converter is designed to operate stably based on electrical characteristics of a single photovoltaic module. The cross-misconnection may create unintended electrical coupling among multiple photovoltaic DC converters, thus disrupting internal closed-loop current control and voltage regulation balance of the photovoltaic DC converter, and further resulting in output fluctuation, abnormal heat generation, and even component damage of the photovoltaic DC converter. Thus, long-term stable operation of the photovoltaic DC converter is seriously threatened.

To address the cross-misconnection issue of photovoltaic connection terminals, a commonly adopted solution in the related art is to perform manual inspection and verification by the staff or the users during mounting of the photovoltaic module (including checking wiring labels and verifying terminal connections one by one). In practical application scenarios, however, on the one hand, the photovoltaic modules, the cables, and the wiring terminals are highly similar without distinct distinguishing features, which easily leads to visual misjudgment. On the other hand, mounting sites often involves complex factors such as narrow spaces and insufficient lighting, further increasing difficulty of manual verification and resulting in a persistently high rate of missed detection. Thus, a potential system risk caused by the cross-misconnection cannot be fundamentally eliminated.

Therefore, how to overcome the drawback of missed detection that is likely to exist during manual inspection in the related art and achieve accurate and efficient detection of cross-misconnection of photovoltaic connection terminals is an urgent problem to be solved at present.

The present disclosure aims to provide a detection method for cross-misconnection of photovoltaic connection terminals, an apparatus, and an electronic device. Based on a first sampled inductor current (local sampled inductor current), a first converted inductor current (local converted inductor current), and a second converted inductor current (other converted inductor current), it is determined that whether the photovoltaic panel negative terminal cross-misconnection exists. With this detection method, firstly, existence and position of the photovoltaic panel negative terminal cross-misconnection can be determined timely and accurately, which is conductive to reducing labor intensity and a likelihood of missed detection, improving detection efficiency and accuracy of a detection result. Secondly, the cross-misconnection of the photovoltaic connection terminals can be effectively detected without increasing a hardware cost, facilitating control of a detection cost. Thirdly, through accurate and efficient detection of the cross-misconnection of the photovoltaic connection terminals, the significant deviation in the collection of the photovoltaic input current can be effectively avoided, ensuring that the maximum power point tracking function of the photovoltaic system does not fail, and enabling the photovoltaic panel to operate at the optimal power generation efficiency point, thereby facilitating the improvement of solar energy utilization efficiency. Also, unintended electrical coupling between the photovoltaic DC converters can be effectively prevented, which is conducive to prolonging a service life of relevant electronic components, ensuring long-term stable operation of the energy storage device.

The detection method and the detection apparatus for cross-misconnection of photovoltaic connection terminals, and the electronic device according to some embodiments of the present disclosure will be described below with reference to FIG. 1 to FIG. 16.

In an embodiment of the present disclosure, a photovoltaic energy storage system 100 includes an energy storage device 110 and a plurality of photovoltaic panels. The plurality of photovoltaic panels are connected to the energy storage device 110 in parallel.

Taking two photovoltaic panels as an example, the two photovoltaic panels are respectively a first photovoltaic panel 120 and a second photovoltaic panel 130.

As illustrated in FIG. 1, FIG. 2, FIG. 3, and FIG. 4, the photovoltaic energy storage system 100 includes the energy storage device 110, the first photovoltaic panel 120, and the second photovoltaic panel 130. The energy storage device 110 is connected to both the first photovoltaic panel 120 and the second photovoltaic panel 130.

Each of the first photovoltaic panel 120 and the second photovoltaic panel 130 serves as a photovoltaic module and is configured to convert the solar energy into the electric energy. The energy storage device 110 is configured to store this electric energy and supply power to some loads based on the power consumption demands.

It should be noted that when the number of photovoltaic panels is three or more, a plurality of first photovoltaic panels 120 are provided, and/or a plurality of second photovoltaic panels 130 are provided.

In an embodiment of the present disclosure, the energy storage device 110 includes a plurality of photovoltaic DC converters and an energy storage battery (battery module 114). Each of the plurality of photovoltaic DC converters is electrically connected to the energy storage battery. Each of the plurality of photovoltaic DC converter is electrically connected to a corresponding photovoltaic panel.

Taking two photovoltaic DC converters as an example, the two photovoltaic DC converters are respectively a first photovoltaic DC converter 111 and a second photovoltaic DC converter 112.

As illustrated in FIG. 1, FIG. 2, FIG. 3, and FIG. 4, the energy storage device 110 includes the first photovoltaic DC converter 111 and the second photovoltaic DC converter 112.

The first photovoltaic DC converter 111 is provided with a first photovoltaic positive device terminal 1111 and a first photovoltaic negative device terminal 1112, and includes a first buck-boost inductor 1113. The first photovoltaic positive device terminal 1111 is configured to be connected to a first panel positive terminal 121 of the first photovoltaic panel 120.

The second photovoltaic DC converter 112 is provided with a second photovoltaic positive device terminal 1121 and a second photovoltaic negative device terminal 1122, and includes a second buck-boost inductor 1123. The second photovoltaic positive device terminal 1121 is configured to be connected to a second panel positive terminal 131 of the second photovoltaic panel 130.

It should be noted that each of the first photovoltaic DC converter 111 and the second photovoltaic DC converter 112 is configured to regulate a voltage of electric energy output by the photovoltaic panel. When the number of photovoltaic DC converters is three or more, a plurality of first photovoltaic DC converters 111 are provided, and/or a plurality of second photovoltaic DC converters 112 are provided.

Under the condition that the plurality of photovoltaic panels are connected in parallel to a same energy storage device 110, the cross-misconnection of the photovoltaic connection terminals may exist.

The following description is given by taking the first photovoltaic panel 120, the second photovoltaic panel 130, the first photovoltaic DC converter 111, and the second photovoltaic DC converter 112 as an example.

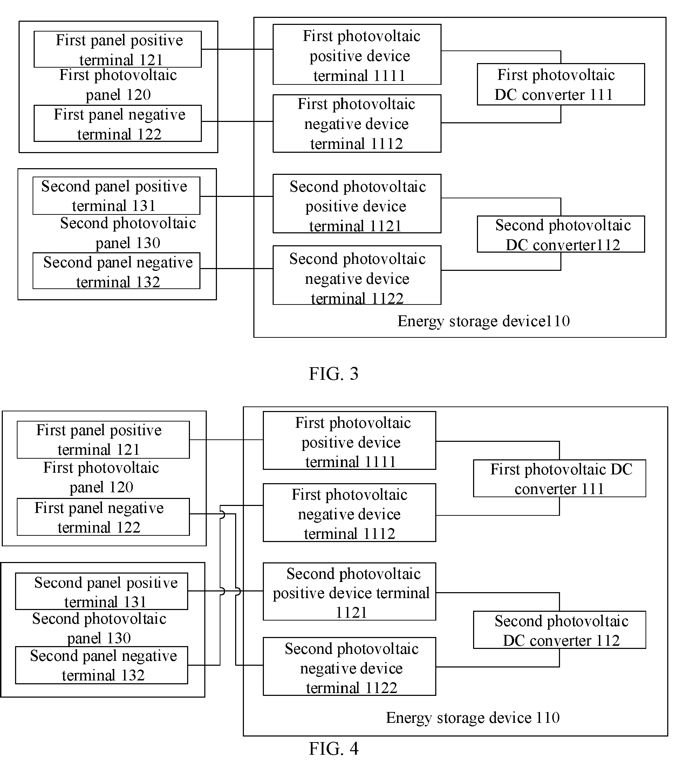

As illustrated in FIG. 3, when the photovoltaic panels are normally connected to the photovoltaic DC converters, the first panel positive terminal 121 of the first photovoltaic panel 120 is connected to the first photovoltaic positive device terminal 1111 of the first photovoltaic DC converter 111, the first panel negative terminal 122 of the first photovoltaic panel 120 is connected to the first photovoltaic negative device terminal 1112 of the first photovoltaic DC converter 111, the second panel positive terminal 131 of the second photovoltaic panel 130 is connected to the second photovoltaic positive device terminal 1121 of the second photovoltaic DC converter 112, and the second panel negative terminal 132 of the second photovoltaic panel 130 is connected to the second photovoltaic negative device terminal 1122 of the second photovoltaic DC converter 112.

As illustrated in FIG. 4, when the cross-misconnection of the photovoltaic connection terminals exists, the first panel positive terminal 121 of the first photovoltaic panel 120 is connected to the first photovoltaic positive device terminal 1111 of the first photovoltaic DC converter 111, the first panel negative terminal 122 of the first photovoltaic panel 120 is erroneously connected to the second photovoltaic negative device terminal 1122 of the second photovoltaic DC converter 112, the second panel positive terminal 131 of the second photovoltaic panel 130 is connected to the second photovoltaic positive device terminal 1121 of the second photovoltaic DC converter 112, and the second panel negative terminal 132 of the second photovoltaic panel 130 is erroneously connected to the first photovoltaic negative device terminal 1112 of the first photovoltaic DC converter 111.

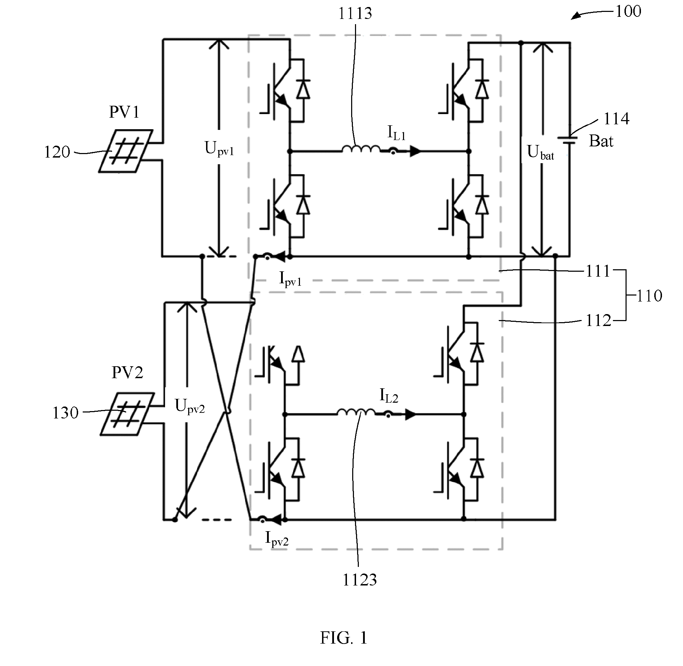

FIG. 2 is a circuit diagram of the photovoltaic energy storage system 100 when the photovoltaic panels are normally connected to the corresponding photovoltaic DC converters. When the photovoltaic panels are normally connected to the corresponding photovoltaic DC converters, taking the first photovoltaic panel 120 and the first photovoltaic DC converter 111 as an example, a current path is: "the first panel positive terminal 121 of the first photovoltaic panel 120→the first photovoltaic positive device terminal 1111 of the first photovoltaic DC converter 111→an internal circuit of the first photovoltaic DC converter 111→the first photovoltaic negative device terminal 1112 of the first photovoltaic DC converter 111→the first panel negative terminal 122 of the first photovoltaic panel 120".

FIG. 1 is a circuit diagram of the photovoltaic energy storage system 100 when the cross-misconnection of the photovoltaic connection terminals exists. When the cross-misconnection of the photovoltaic connection terminals exists, taking the first photovoltaic panel 120 as an example, a current path is: "the first panel positive terminal 121 of the first photovoltaic panel 120→the first photovoltaic positive device terminal 1111 of the first photovoltaic DC converter 111→the internal circuit of the first photovoltaic DC converter 111→the first photovoltaic negative device terminal 1112 of the first photovoltaic DC converter 111→the second photovoltaic negative device terminal 1122 of the second photovoltaic DC converter 112→the first panel negative terminal 122 of the first photovoltaic panel 120".

It should be noted that the plurality of photovoltaic DC converters share a common ground. Therefore, negative terminals (photovoltaic negative device terminals) of the plurality of photovoltaic DC converters are interconnected.

In a technical solution of the present disclosure, a sampling point for the photovoltaic input current is arranged at the negative terminal (photovoltaic negative device terminal) of the photovoltaic DC converter. Under the dual conditions that the cross-misconnection of the photovoltaic connection terminals exists and the plurality of photovoltaic DC converters share a common ground, a sampled current is exactly an input current of "a photovoltaic panel that is cross-misconnected to this photovoltaic DC converter". This detection method is beneficial for accurately and efficiently detecting a photovoltaic cross-connection error.

In some embodiments, the energy storage device 110 includes an energy management system (EMS) module. The EMS module is configured to communicate with an energy storage management cloud platform and/or a user terminal.

In a specific embodiment, when it is determined that the photovoltaic panel negative terminal cross-misconnection exists, the energy storage device 110 transmits cross-misconnection fault information to the energy storage management cloud platform via the EMS module, and the energy storage management cloud platform transmits reminder information (cross-misconnection prompt information) to the user terminal based on the cross-misconnection fault information.

In a specific embodiment, when it is determined that the photovoltaic panel negative terminal cross-misconnection exists, the energy storage device 110 transmits the cross-misconnection fault information to the user terminal via the EMS module.

It should be noted that the user terminal may be a mobile phone, a laptop computer or other devices.

In an embodiment of the present disclosure, the detection method for cross-misconnection of photovoltaic connection terminals is applied to the energy storage device 110.

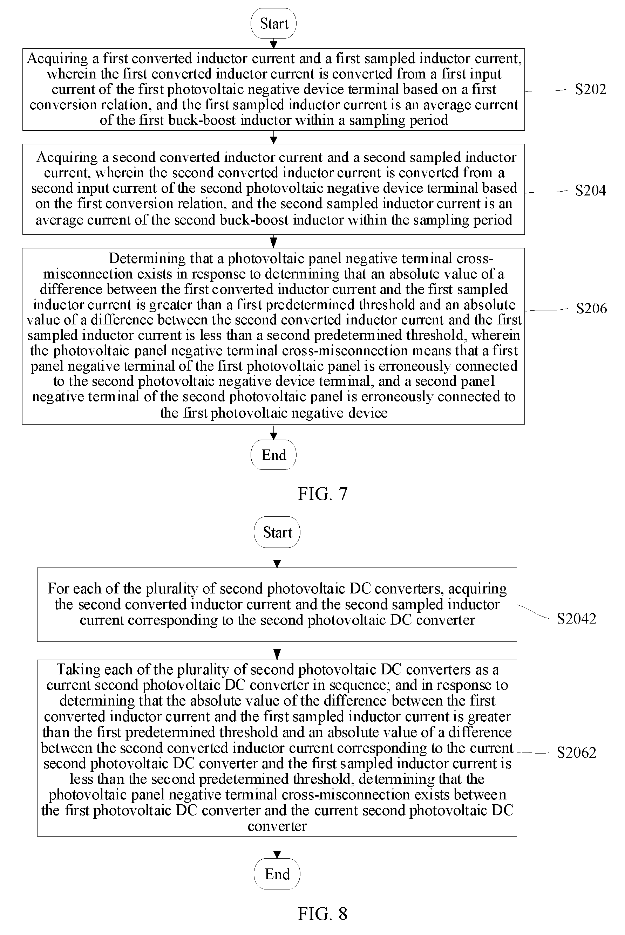

As illustrated in FIG. 7, the detection method for cross-misconnection of photovoltaic connection terminals includes the following steps S202 to S204.

At S202, the first converted inductor current and the first sampled inductor current are acquired. The first converted inductor current is converted from a first input current of the first photovoltaic negative device terminal based on a first conversion relation, and the first sampled inductor current is an average current of the first buck-boost inductor within a sampling period.

It should be noted that if the sampling point for the photovoltaic input current is arranged at the negative terminal (panel negative terminal) of the photovoltaic panel, the sampled current at the negative terminal of the photovoltaic panel will always be "an output current of the local photovoltaic circuit" regardless of whether the cross-misconnection exists, and thus a wiring fault cannot be reflected.

Since the plurality of photovoltaic DC converters share a common ground in a non-isolated photovoltaic system, the negative terminals (photovoltaic negative device terminals) of the plurality of photovoltaic DC converters are connected with each other. By arranging the sampling point for the photovoltaic input current at the negative terminal (photovoltaic negative device terminal) of the photovoltaic DC converter, an input current of "the photovoltaic panel that is cross-misconnected to this photovoltaic DC converter" can be sampled.

The sampling point for the photovoltaic input current is arranged at the negative terminal (photovoltaic negative device terminal) of the photovoltaic DC converter. Under the dual conditions that the cross-misconnection of the photovoltaic connection terminals exists and the plurality of photovoltaic DC converters share a common ground, the sampled current is exactly the input current of "the photovoltaic panel that is cross-misconnected to this photovoltaic DC converter". This detection method is beneficial for accurately and efficiently detecting the photovoltaic cross-connection error.

By acquiring the first sampled inductor current and the first converted inductor current, it is convenient to compare the first sampled inductor current and the first converted inductor current in the subsequent operations to determine whether the photovoltaic panel negative terminal cross-misconnection exists.

It should be noted that the first sampled inductor current is taken as the local sampled inductor current, and the first converted inductor current is taken as the local converted inductor current.

In some implementations, the average current of the first buck-boost inductor within the sampling period is taken as the first sampled inductor current. The first converted inductor current is determined based on the first input current and the first conversion relation.

In a specific embodiment, the first converted inductor current is calculated by multiplying a sampled input current of the first photovoltaic panel (the first input current of the first photovoltaic negative device terminal) by an output duty cycle of the first photovoltaic DC converter.

After a photovoltaic DC/DC (Direct Current to Direct Current) converter operates stably, there is a corresponding conversion relation between an inductor current and an input current.

Taking a four-switch photovoltaic converter (a specific form of the photovoltaic DC converter) as an example, a converted inductor current is calculated by multiplying the input current by a corresponding output duty cycle (bridge arm duty cycle). Theoretically, the converted inductor current is equal to a periodic average value of the sampled inductor current.

At S204, the second converted inductor current and a second sampled inductor current are acquired. The second converted inductor current is converted from a second input current of the second photovoltaic negative device terminal based on the first conversion relation, and the second sampled inductor current is an average current of the second buck-boost inductor within the sampling period.

It should be noted that the second sampled inductor current is taken as the other sampled inductor current, and the second converted inductor current is taken as the other converted inductor current. When the plurality of second photovoltaic DC converters are provided and the plurality of second photovoltaic panels are provided, the second converted inductor current and the second sampled inductor current corresponding to each of the plurality of second photovoltaic DC converters are acquired. In the subsequent operations, each second converted inductor current is compared with the first sampled inductor current to check whether the cross-misconnection exists and determine a position where the cross-misconnection exists.

In some implementations, the average current of the second buck-boost inductor within the sampling period is taken as the second sampled inductor current. The second converted inductor current is determined based on the second input current and a second conversion relation.

The second converted inductor current is calculated by multiplying a sampled input current of the second photovoltaic panel (the second input current of the second photovoltaic negative device terminal) by a first bridge arm duty cycle of the first photovoltaic DC converter.

At S206, it is determined that the photovoltaic panel negative terminal cross-misconnection exists in response to determining that an absolute value of a difference between the first converted inductor current and the first sampled inductor current is greater than a first predetermined threshold, and an absolute value of a difference between the second converted inductor current and the first sampled inductor current is less than a second predetermined threshold. The photovoltaic panel negative terminal cross-misconnection means that the first panel negative terminal of the first photovoltaic panel is erroneously connected to the second photovoltaic negative device terminal, and the second panel negative terminal of the second photovoltaic panel is erroneously connected to the first photovoltaic negative device terminal.

The local converted inductor current (the first converted inductor current) is compared with the local sampled inductor current (the first sampled inductor current). A comparison result between the local converted inductor current and the local sampled inductor current is used as a determination condition to determine whether the cross-misconnection exists. In view of actual sampling and calculation deviations, the first predetermined threshold is set. When an absolute value of a difference between the local converted inductor current and the local sampled inductor current is greater than the first predetermined threshold, it is preliminarily determined that the cross-misconnection may exist.

A comparison result between the other converted inductor current (the second converted inductor current) and the local sampled inductor current (the first sampled inductor current) is used as another determination condition to determine whether the cross-misconnection exists and locate the position where the cross-misconnection exists. In view of the actual sampling and calculation deviations, the second predetermined threshold is set. When an absolute value of a difference between the other converted inductor current and the local sampled inductor current is less than the second predetermined threshold, it is determined that the cross-misconnection exists.

The present disclosure aims to provide a detection method for cross-misconnection of photovoltaic connection terminals. Based on the first sampled inductor current (the local sampled inductor current), the first converted inductor current (the local converted inductor current), and the second converted inductor current (the other converted inductor current), it is determined that whether the photovoltaic panel negative terminal cross-misconnection exists. With this detection method, firstly, the existence and position of the photovoltaic panel negative terminal cross-misconnection can be determined timely and accurately, which is conductive to reducing the labor intensity and the likelihood of missed detection, improving the detection efficiency and the accuracy of the detection result. Secondly, the cross-misconnection of the photovoltaic connection terminals can be effectively detected without increasing the hardware cost, facilitating control of the detection cost. Thirdly, through the accurate and efficient detection of the cross-misconnection of the photovoltaic connection terminals, the significant deviation in the collection of the photovoltaic input current can be effectively avoided, ensuring that the maximum power point tracking function of the photovoltaic system does not fail, and enabling the photovoltaic panel to operate at the optimal power generation efficiency point, thereby facilitating the improvement of the solar energy utilization efficiency. Also, the unintended electrical coupling between the photovoltaic DC converters can be effectively prevented, which is conducive to prolonging the service life of relevant electronic components, ensuring the long-term stable operation of the energy storage device.

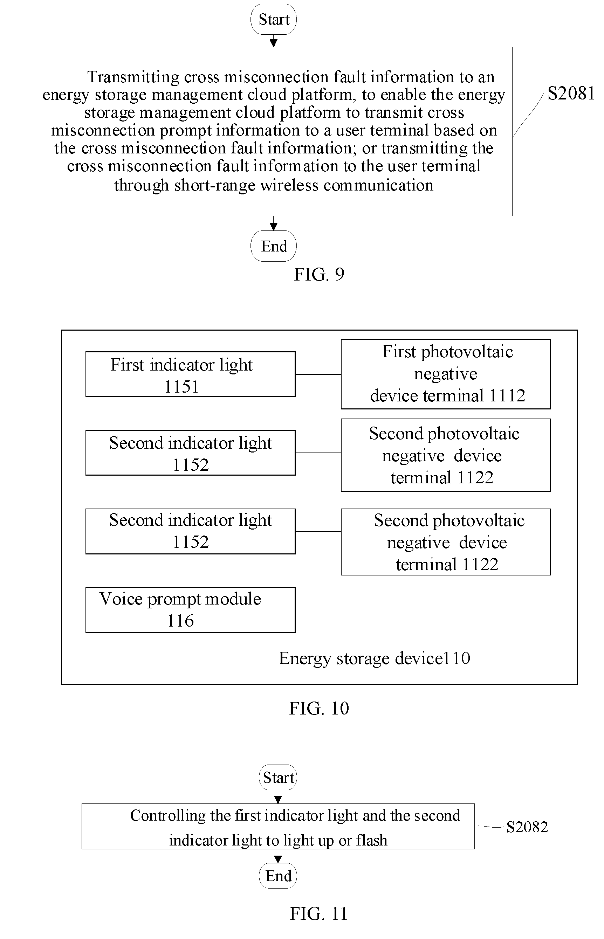

In some embodiments, as illustrated in FIG. 9, the detection method for the cross-misconnection of the photovoltaic connection terminals further includes, subsequent to said determining that the photovoltaic panel negative terminal cross-misconnection exists:

S2081, transmitting the cross-misconnection fault information to the energy storage management cloud platform, to enable the energy storage management cloud platform to transmit the cross-misconnection prompt information to the user terminal based on the cross-misconnection fault information; or transmitting the cross-misconnection fault information to the user terminal through short-range wireless communication.

When it is determined that the photovoltaic panel negative terminal cross-misconnection exists, the EMS module of the energy storage device is configured to transmit the cross-misconnection fault information to the energy storage management cloud platform, or transmit the cross-misconnection fault information to the user terminal through the short-range wireless communication.

When it is determined that the photovoltaic panel negative terminal cross-misconnection exists, the energy storage management cloud platform is configured to: receive the cross-misconnection fault information from the EMS module and transmit the cross-misconnection prompt information to the user terminal based on the cross-misconnection fault information.

When it is determined that the photovoltaic panel negative terminal cross-misconnection exists, the EMS module of the energy storage device is configured to transmit the cross-misconnection fault information to the user terminal. The user terminal is configured to receive the cross-misconnection fault information from the EMS module.

A fault position is identified timely, and the staff or the users are reminded or notified to inspect wiring. This design facilitates reducing the labor intensity and the likelihood of missed detection, improving the detection efficiency and the accuracy of the detection result.

In some embodiments, the cross-misconnection fault information includes position information of the cross-misconnection, a time point when the cross-misconnection occurs, and a time duration of the cross-misconnection.

In some embodiments, as illustrated in FIG. 10, the energy storage device 110 further includes a first indicator light 1151 and a second indicator light 1152. The first indicator light 1151 is disposed at the first photovoltaic negative device terminal 1112, and the second indicator light 1152 is disposed at the second photovoltaic negative device terminal 1122.

In a specific embodiment, the first indicator light 1151 is disposed at or disposed adjacent to the first photovoltaic negative device terminal 1112. The second indicator light 1152 is disposed at or disposed adjacent to the second photovoltaic negative device terminal 1122.

In some embodiments, as illustrated in FIG. 11, the detection method for the cross-misconnection of the photovoltaic connection terminals further includes, subsequent to said determining that the photovoltaic panel negative terminal cross-misconnection exists:

S2082, controlling the first indicator light and the second indicator light to light up or flash.

It should be noted that, a color and a flashing frequency of the first indicator light, and a color and a flashing frequency of the second indicator light are flexibly set based on actual requirements.

By providing the indicator lights, it is convenient for the staff or the users to timely and accurately determine the existence and position of the photovoltaic panel negative terminal cross-misconnection, which is conducive to reducing the labor intensity and the likelihood of missed detection.

In some embodiments, as illustrated in FIG. 10, the energy storage device 110 further includes a voice prompt module 116. The voice prompt module 116 is configured to broadcast the cross-misconnection fault information.

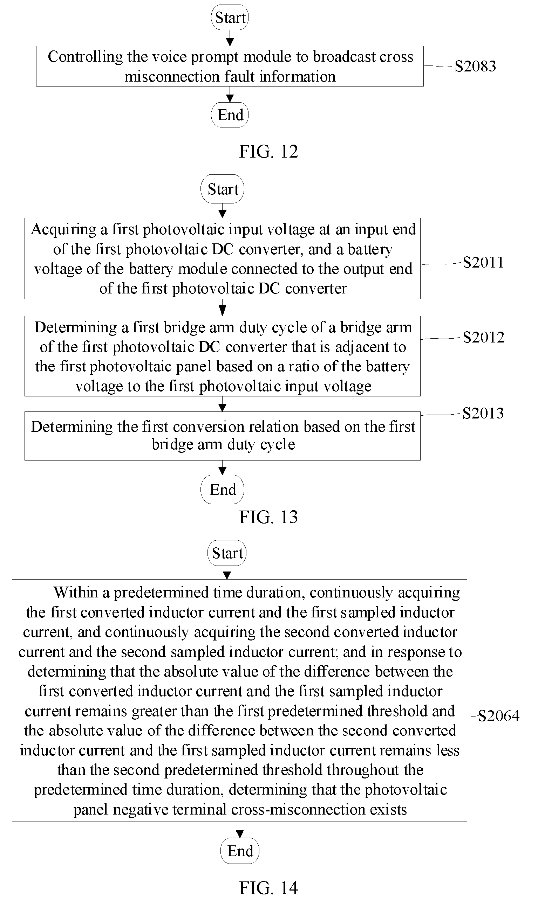

In some embodiments, as illustrated in FIG. 12, the detection method for the cross-misconnection of the photovoltaic connection terminals further includes, subsequent to said determining that the photovoltaic panel negative terminal cross-misconnection exists:

S2083, controlling the voice prompt module to broadcast the cross-misconnection fault information.

It should be noted that volume and broadcast times of the voice prompt module are flexibly set based on the actual requirements.

By providing the voice prompt module, it is convenient for the staff or the users to timely and accurately determine the existence and position of the photovoltaic panel negative terminal cross-misconnection, which is conducive to reducing the labor intensity and the likelihood of missed detection.

In some embodiments, as illustrated in FIG. 1 and FIG. 2, the energy storage device further includes a battery module 114. Each of an output end of the first photovoltaic DC converter 111 and an output end of the second photovoltaic DC converter 112 is connected to the battery module 114. In other words, each of the first photovoltaic DC converter 111 and the second photovoltaic DC converter 112 is connected to the same battery module 114 in parallel.

As illustrated in FIG. 13, the detection method for cross-misconnection of photovoltaic connection terminals further includes the following steps S2011 to S2013.

At S2011, a first photovoltaic input voltage at an input end of the first photovoltaic DC converter is acquired, and a battery voltage of the battery module connected to the output end of the first photovoltaic DC converter.

The energy storage device includes a first voltage sensor. The first voltage sensor is disposed at the input end of the first photovoltaic DC converter and configured to acquire the first photovoltaic input voltage at the input end of the first photovoltaic DC converter.

The energy storage device further includes a second voltage sensor. The second voltage sensor is disposed at the battery module and configured to acquire the battery voltage of the battery module.

At S2012, a first bridge arm duty cycle of a bridge arm of the first photovoltaic DC converter that is adjacent to the first photovoltaic panel is determined based on a ratio of the battery voltage to the first photovoltaic input voltage.

At S2013, the first conversion relation is determined based on the first bridge arm duty cycle.

The first converted inductor current is determined based on the first input current and the first conversion relation.

The first converted inductor current is calculated by multiplying the sampled input current of the first photovoltaic panel (the first input current of the first photovoltaic negative device terminal) by the output duty cycle of the first photovoltaic DC converter.

The local converted inductor current is compared with the local sampled inductor current. The comparison result between the local converted inductor current and the local sampled inductor current is used as a determination condition to determine whether the cross-misconnection exists.

In the photovoltaic DC converter, the first bridge arm duty cycle is a core parameter describing an operating state of an internal switching transistor of the photovoltaic DC converter. Specifically, the first bridge arm duty cycle refers to a ratio of on-time of the switching transistor in one operating cycle to the entire cycle, which is generally denoted as a percentage or a decimal.

In some embodiments, a minimum value between a first ratio and 1 is used as the first bridge arm duty cycle of the first photovoltaic DC converter. The first ratio is the ratio of the battery voltage to the first photovoltaic input voltage.

By using the minimum value between the first ratio and 1 as the first bridge arm duty cycle of the first photovoltaic DC converter, the first bridge arm duty cycle can be controlled within a safe range from 0 to 1, which helps ensure accuracy of the converted inductor current.

In some embodiments, as illustrated in FIG. 14, said determining that the photovoltaic panel negative terminal cross-misconnection exists in response to determining that the absolute value of the difference between the first converted inductor current and the first sampled inductor current is greater than the first predetermined threshold, and the absolute value of the difference between the second converted inductor current and the first sampled inductor current is less than the second predetermined threshold includes operation at step 2064.

At S2064, within a predetermined time duration, the first converted inductor current and the first sampled inductor current are continuously acquired, the second converted inductor current and the second sampled inductor current are continuously acquired; and it is determined that the photovoltaic panel negative terminal cross-misconnection exists in response to determining that the absolute value of the difference between the first converted inductor current and the first sampled inductor current remains greater than the first predetermined threshold throughout the predetermined time duration and the absolute value of the difference between the second converted inductor current and the first sampled inductor current remains less than the second predetermined threshold throughout the predetermined time duration.

A third determination condition is added on the basis of the two existing determination conditions, which is to determine whether a time duration during which the two determination conditions are satisfied is greater than or equal to the predetermined time duration.

When the first determination condition and the second determination condition are satisfied while the third determination condition is not satisfied (the time duration is less than the predetermined time duration), it indicates that the two determination conditions are only temporarily satisfied due to transient current fluctuations before returning to normal. Such a case is determined as an interference signal, and no fault alarm is triggered (the EMS module does not transmit the cross-misconnection fault information).

When all three determination conditions are satisfied, it is determined that the photovoltaic panel negative terminal cross-misconnection exists. The EMS module is configured to transmit the cross-misconnection fault information to remind or notify the staff or the users to check the wiring.

On the basis of two determination conditions, a limitation that "a time duration during which determination conditions are satisfied is greater than or equal to a predetermined time duration" is added to form a composite detection logic of "dual difference determination and time verification". This detection method can filter out a short-duration interference signal, which is conducive to improving the accuracy of the detection result, avoiding misjudgment to a great extent.

In some embodiments, the first predetermined threshold ranges from 1 A to 3 A.

A value range of the first predetermined threshold is defined. Firstly, an excessively small first predetermined threshold is avoided, so that numerical sampling and numerical calculation (conversion) can effectively tolerate inherent errors existing in numerical sampling and current conversion processes of the photovoltaic energy storage system within a certain error range. Secondly, an excessively large first predetermined threshold is avoided, which helps ensure detection sensitivity, thus accurately detecting whether the cross-misconnection of the photovoltaic connection terminals exists.

In a specific embodiment, the first predetermined threshold is 1 A.

In a specific embodiment, the first predetermined threshold is 1.5 A.

In a specific embodiment, the first predetermined threshold is 2 A.

In a specific embodiment, the first predetermined threshold is 2.5 A.

In a specific embodiment, the first predetermined threshold is 3 A.

In some embodiments, the second predetermined threshold ranges from 1 A to 3 A.

A value range of the second predetermined threshold is defined. Firstly, an excessively small second predetermined threshold is avoided, so that the numerical sampling and the numerical calculation (conversion) can effectively tolerate the inherent errors existing in the numerical sampling and current conversion processes of the photovoltaic energy storage system within a certain error range. Secondly, an excessively large second predetermined threshold is avoided, which helps ensure the detection sensitivity, thus accurately detecting whether the cross-misconnection of the photovoltaic connection terminals exists.

In a specific embodiment, the second predetermined threshold is 1 A.

In a specific embodiment, the second predetermined threshold is 1.5 A.

In a specific embodiment, the second predetermined threshold is 2 A.

In a specific embodiment, the second predetermined threshold is 2.5 A.

In a specific embodiment, the second predetermined threshold is 3 A.

In some embodiments, the predetermined time duration ranges from 1 s to 3 s.

A value range of the predetermined time duration is defined. Firstly, an excessively short predetermined time duration is avoided to ensure that the short-duration interference signal can be filtered out, thus improving the accuracy of the detection result. Secondly, an excessively long predetermined time duration is prevented, which helps improve the detection efficiency.

In a specific embodiment, the predetermined time duration is 1 s.

In a specific embodiment, the predetermined time duration is 1.5 s.

In a specific embodiment, the predetermined time duration is 2 s.

In a specific embodiment, the predetermined time duration is 2.5 s.

In a specific embodiment, the predetermined time duration is 3 s.

In some embodiments, two photovoltaic modules (two photovoltaic panels) and two photovoltaic DC converters are taken as an example. The two photovoltaic modules are respectively a first photovoltaic module (the first photovoltaic panel, denoted as PV1) and a second photovoltaic module (the second photovoltaic panel, denoted as PV2). The two photovoltaic DC converters are respectively a first photovoltaic DC converter and a second photovoltaic DC converter. The first photovoltaic module is arranged corresponding to the first photovoltaic DC converter, and the second photovoltaic module is arranged corresponding to the second photovoltaic DC converter.

When the cross-misconnection of the photovoltaic connection terminals exists, the first panel positive terminal of the first photovoltaic panel is connected to the first photovoltaic positive device terminal of the first photovoltaic DC converter, the first panel negative terminal of the first photovoltaic panel is erroneously connected to the second photovoltaic negative device terminal of the second photovoltaic DC converter, the second panel positive terminal of the second photovoltaic panel is connected to the second photovoltaic positive device terminal of the second photovoltaic DC converter, and the second panel negative terminal of the second photovoltaic panel is erroneously connected to the first photovoltaic negative device terminal of the first photovoltaic DC converter.

An input current of the negative terminal of the first photovoltaic DC converter is sampled and defined as a sampled input current of the first photovoltaic module, denoted as Iₚᵥ₁. An input current of the negative terminal of the second photovoltaic DC converter is sampled and defined as a sampled input current of the second photovoltaic module, denoted as Iₚᵥ₂.

An input voltage of the first photovoltaic module (an input voltage of the first photovoltaic panel) is acquired and denoted as Uₚᵥ₁. An input voltage of the second photovoltaic module (an input voltage of the second photovoltaic panel) is acquired and denoted as Uₚᵥ₂. The battery voltage of the energy storage device (the battery voltage is shared and thus base values are substantially equal) is acquired and denoted as U_{bat}.

It should be noted that "bat" or "Bat" is used to represent the battery module of the energy storage device.

The average current of the first buck-boost inductor within the sampling period is used as the first sampled inductor current, denoted as I_{L1}. The average current of the second buck-boost inductor within the sampling period is taken as the second sampled inductor current, denoted as I_{L2}.

It should be noted that "L1" represents the first buck-boost inductor, and "L2" represents the second buck-boost inductor.

Two determination conditions need to be satisfied to determine whether the cross-misconnection exists between the first photovoltaic module and the second photovoltaic module.

One determination condition is: whether the absolute value of the difference between the local converted inductor current and the local sampled inductor current is greater than the first predetermined threshold.

The other determination condition is: whether the absolute value of the difference between the other converted inductor current and the local sampled inductor current is less than the second predetermined threshold.

An input current is converted into an inductor current, and a conversion relation is as follows: ${D}_{pv 1} = min \left({U}_{bat}/{U}_{pv 1}, 1\right) ;$ ${D}_{pv 2} = min \left({U}_{bat}/{U}_{pv 2}, 1\right) ;$ ${I}_{L 1 _ temp} = {I}_{pv 1} \times {D}_{pv 1} ;$ ${I}_{L 2 _ temp} = {I}_{pv 2} \times {D}_{pv 2} ;$ ${I}_{L 3 _ temp} = {I}_{pv 2} \times {D}_{pv 1} ;$ ${I}_{L 4 _ temp} = {I}_{pv 1} \times {D}_{pv 2} .$

D_{py1} represents the output duty cycle of the first photovoltaic DC converter. Dₚᵥ₂ represents an output duty cycle of the second photovoltaic DC converter. Dₚᵥ₁ corresponds to a duty cycle of a bridge arm connected to the first photovoltaic module. Dₚᵥ₂ corresponds to a duty cycle of a bridge arm connected to the second photovoltaic module. Each of Dₚᵥ₁ and Dₚᵥ₂ has a maximum value of 1. Dₚᵥ₁ and Dₚᵥ₂ respectively correspond the first converted relation and the second converted relation.

"min" denotes taking the minimum value. Each of "U_{bat}/Uₚᵥ₁" and "U_{bat}/Uₚᵥ₂" represents the first ratio.

I_{L1_temp}, I_{L2_temp}, I_{L3_temp}, and I_{L4_temp} each represent the converted inductor current, i.e., corresponding respectively to the first converted inductor current, the third converted inductor current, the second converted inductor current, and the fourth converted inductor current. Each of I_{L1_temp} and I_{L2_temp} specifically represents the local converted inductor current. Each of I_{L3_temp} and I_{L4_temp} specifically represents the other converted inductor current.

One determination condition is: |I_{L1_temp}-I_{L1}|>Iₜₕ₁, and |I_{L2_temp}-I_{L2}|>Iₜₕ₁. Iₜₕ₁ represents the first predetermined threshold.

The other determination condition is: |I_{L3_temp}-I_{L1}|<Iₜₕ₂, and |I_{L4_temp}-I_{L2}|<Iₜₕ₂. Iₜₕ₂ represents the second predetermined threshold.

When the above two determination conditions are both satisfied and the time duration during which the two determination conditions are satisfied is greater than or equal to the predetermined time duration, it is determined that the cross-misconnection of the photovoltaic connection terminals exists, and the cross-misconnection fault information is reported to a control platform (the energy storage management cloud platform) or the user terminal. For example, when the above two determination conditions are continuously satisfied for 2s, the cross-misconnection fault information is reported.

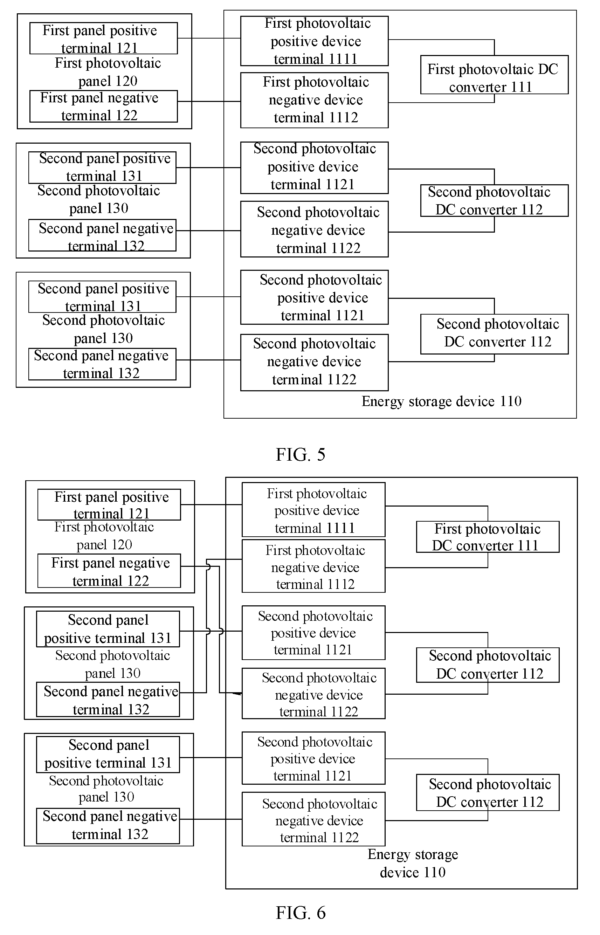

In some embodiments, as illustrated in FIG. 5 and FIG. 6, the plurality of second photovoltaic DC converters 112 are provided, and the plurality of second photovoltaic panels 130 are provided. The second photovoltaic positive device terminal 1121 of each of the plurality of second photovoltaic DC converters 112 is connected to the second panel positive terminal 131 of the corresponding second photovoltaic panel 130.

FIG. 5 illustrates a scenario where the plurality of second photovoltaic DC converters 112 and the plurality of second photovoltaic panels 130 are provided, and each photovoltaic panel (including the first photovoltaic panel 120 and the second photovoltaic panels 130) is normally connected to a corresponding photovoltaic DC converter (including the first photovoltaic DC converter 111 and the second photovoltaic DC converter 112) (without any cross-misconnection).

FIG. 6 illustrates a scenario where the plurality of second photovoltaic DC converters 112 and the plurality of second photovoltaic panels 130 are provided, one of the second photovoltaic DC converters 112 is cross-misconnected to the first photovoltaic panel 120, and one of the second photovoltaic panels 130 is cross-misconnected to the first photovoltaic DC converter 111.

In some embodiments, as illustrated in FIG. 8, acquiring the second converted inductor current and the second sampled inductor includes:

S2042, acquiring the second converted inductor current and the second sampled inductor corresponding to each of the plurality of second photovoltaic DC converters.

When the plurality of second photovoltaic DC converters are provided and the plurality of second photovoltaic panels are provided, the second converted inductor current and the second sampled inductor current corresponding to each of the plurality of second photovoltaic DC converters are acquired. In the subsequent operations, each second converted inductor current is compared with the first sampled inductor current to check whether the cross-misconnection exists and determine the position where the cross-misconnection exists.

In some embodiments, said determining that the photovoltaic panel negative terminal cross-misconnection exists in response to determining that the absolute value of the difference between the first converted inductor current and the first sampled inductor current is greater than the first predetermined threshold, and the absolute value of the difference between the second converted inductor current and the first sampled inductor current is less than the second predetermined threshold includes:

S2062, using each of the plurality of second photovoltaic DC converters as a current second photovoltaic DC converter in sequence; and in response to determining that the absolute value of the difference between the first converted inductor current and the first sampled inductor current is greater than the first predetermined threshold and an absolute value of a difference between the second converted inductor current corresponding to the current second photovoltaic DC converter and the first sampled inductor current is less than the second predetermined threshold, determining that the photovoltaic panel negative terminal cross-misconnection exists between the first photovoltaic DC converter and the current second photovoltaic DC converter.

When the plurality of photovoltaic panels are provided, by comparing each second converted inductor current with the first sampled inductor current, it is conducive to accurately checking whether the cross-misconnection exists and determining the position where the cross-misconnection exists.

The first converted inductor current is compared with the first sampled inductor current to determine whether the cross-misconnection exists. Each second converted inductor current is compared with the first sampled inductor current to determine whether the cross-misconnection exists and locate the position of such cross-misconnection. With this design, when the cross-misconnection exists, it is convenient for the staff or the users to timely and accurately determine the existence and position of the photovoltaic panel negative terminal cross-misconnection, which is conducive to reducing the labor intensity and the likelihood of missed detection.

In an embodiment of the present disclosure, a detection apparatus 300 for cross-misconnection of photovoltaic connection terminals is applied to the energy storage device 110.

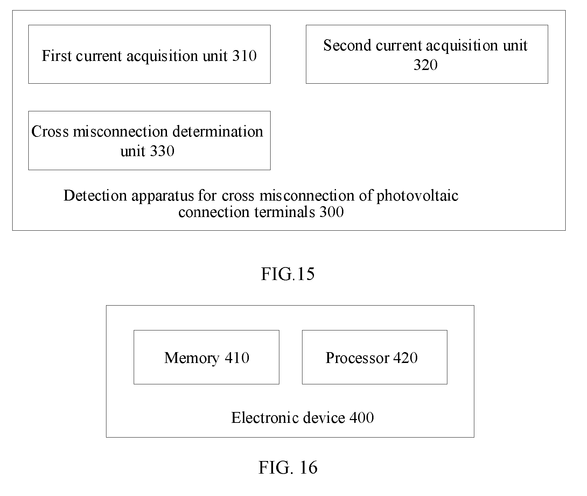

As illustrated in FIG. 15, the detection apparatus 300 for cross-misconnection of photovoltaic connection terminals includes a first current acquisition unit 310, a second current acquisition unit 320, and a cross-misconnection determination unit 330.

The first current acquisition unit 310 is configured to acquire the first converted inductor current and the first sampled inductor current. The first converted inductor current is converted from the first input current of the first photovoltaic negative device terminal 1112 based on the first conversion relation. The first sampled inductor current is the average current of the first buck-boost inductor 1113 within the sampling period.

It should be noted that if the sampling point for the photovoltaic input current is arranged at the negative terminal (panel negative terminal) of the photovoltaic panel, the sampled current at the negative terminal of the photovoltaic panel will always be "the output current of the local photovoltaic circuit" regardless of whether the cross-misconnection exists, and thus the wiring fault cannot be reflected.

Since the plurality of photovoltaic DC converters share a common ground in the non-isolated photovoltaic system, the negative terminals (photovoltaic negative device terminals) of the plurality of photovoltaic DC converters are connected with each other. By arranging the sampling point for the photovoltaic input current at the negative terminal (photovoltaic negative device terminal) of the photovoltaic DC converter, the input current of "the photovoltaic panel that is cross-misconnected to this photovoltaic DC converter" can be sampled.

The sampling point for the photovoltaic input current is arranged at the negative terminal (photovoltaic negative device terminal) of the photovoltaic DC converter. Under the dual conditions that the cross-misconnection of the photovoltaic connection terminals exists and the plurality of photovoltaic DC converters share a common ground, the sampled current is exactly the input current of "the photovoltaic panel that is cross-misconnected to this photovoltaic DC converter". This detection method is beneficial for accurately and efficiently detecting the photovoltaic cross-connection error.

By acquiring the first sampled inductor current and the first converted inductor current, it is convenient to perform numerical comparison between the first sampled inductor current and the first converted inductor current in the subsequent operations to determine whether the photovoltaic panel negative terminal cross-misconnection exists.

It should be noted that the first sampled inductor current is taken as the local sampled inductor current, and the first converted inductor current is taken as the local converted inductor current.

In some implementations, the average current of the first buck-boost inductor 113 within the sampling period is taken as the first sampled inductor current. The first converted inductor current is determined based on the first input current and the first conversion relation.

In a specific embodiment, the first converted inductor current is calculated by multiplying a sampled input current of the first photovoltaic panel 120 (the first input current of the first photovoltaic negative device terminal 1112) by an output duty cycle of the first photovoltaic DC converter 111.

After the photovoltaic DC/DC (Direct Current to Direct Current) converter operates stably, there is the corresponding conversion relation between the inductor current and the input current.

Taking the four-switch photovoltaic converter (a specific form of the photovoltaic DC converter) as an example, the converted inductor current is calculated by multiplying the input current by the corresponding output duty cycle (bridge arm duty cycle). Theoretically, the converted inductor current is equal to the periodic average value of the sampled inductor current.

The second current acquisition unit 320 is configured to acquire the second converted inductor current and the second sampled inductor current. The second converted inductor current is converted from the second input current of the second photovoltaic negative device terminal 1122 based on the first conversion relation. The second sampled inductor current is the average current of the second buck-boost inductor 1123 within the sampling period.

It should be noted that the second sampled inductor current is taken as the other sampled inductor current, and the second converted inductor current is taken as the other converted inductor current. When the plurality of second photovoltaic DC converters 112 are provided and the plurality of second photovoltaic panels 130 are provided, the second converted inductor current and the second sampled inductor current corresponding to each of the plurality of second photovoltaic DC converters 112 are acquired. In the subsequent operations, each second converted inductor current is compared with the first sampled inductor current to check whether the cross-misconnection exists and determine the position where the cross-misconnection exists.

In some implementations, the average current of the second buck-boost inductor 1123 within the sampling period is used as the second sampled inductor current. The second converted inductor current is determined based on the second input current and the second conversion relation.

The second converted inductor current is calculated by multiplying a sampled input current of the second photovoltaic panel 130 (the second input current of the second photovoltaic negative device terminal 1122) by the output duty cycle of the first photovoltaic DC converter 111.

The cross-misconnection determination unit 330 is configured to determine that the photovoltaic panel negative terminal cross-misconnection exists in response to determining that the absolute value of the difference between the first converted inductor current and the first sampled inductor current is greater than the first predetermined threshold, and the absolute value of the difference between the second converted inductor current and the first sampled inductor current is less than the second predetermined threshold. The photovoltaic panel negative terminal cross-misconnection means that the first panel negative terminal 122 of the first photovoltaic panel 120 is erroneously connected to the second photovoltaic negative device terminal 1122, and the second panel negative terminal 132 of the second photovoltaic panel 130 is erroneously connected to the first photovoltaic negative device terminal 1112.

The local converted inductor current (the first converted inductor current) is compared with the local sampled inductor current (the first sampled inductor current). The comparison result between the local converted inductor current and the local sampled inductor current is used as the determination condition to determine whether the cross-misconnection exists. In view of the actual sampling and calculation deviations, the first predetermined threshold is set. When the absolute value of the difference between the local converted inductor current and the local sampled inductor current is greater than the first predetermined threshold, it is preliminarily determined that the cross-misconnection may exist.

The comparison result between the other converted inductor current (the second converted inductor current) and the local sampled inductor current (the first sampled inductor current) is used as another determination condition to determine whether the cross-misconnection exists and locate the position where the cross-misconnection exists. In view of the actual sampling and calculation deviations, the second predetermined threshold is set. When the absolute value of the difference between the other converted inductor current and the local sampled inductor current is less than the second predetermined threshold, it is determined that the cross-misconnection exists.

The present disclosure aims to provide a detection apparatus 300 for cross-misconnection of photovoltaic connection terminals. Based on the first sampled inductor current (the local sampled inductor current), the first converted inductor current (the local converted inductor current), and the second converted inductor current (the other converted inductor current), it is determined that whether the photovoltaic panel negative terminal cross-misconnection exists. With this detection method, firstly, the existence and position of the photovoltaic panel negative terminal cross-misconnection can be determined timely and accurately, which is conductive to reducing the labor intensity and the likelihood of missed detection, improving the detection efficiency and the accuracy of the detection result. Secondly, the cross-misconnection of the photovoltaic connection terminals can be effectively detected without increasing the hardware cost, facilitating control of the detection cost. Thirdly, through the accurate and efficient detection of the cross-misconnection of the photovoltaic connection terminals, the significant deviation in the collection of the photovoltaic input current can be effectively avoided, ensuring that the maximum power point tracking function of the photovoltaic system does not fail, and enabling the photovoltaic panel to operate at the optimal power generation efficiency point, thereby facilitating the improvement of the solar energy utilization efficiency. Also, the unintended electrical coupling between the photovoltaic DC converters can be effectively prevented, which is conducive to prolonging the service life of relevant electronic components, ensuring the long-term stable operation of the energy storage device 110.

In an embodiment of the present disclosure, as illustrated in FIG. 16, an electronic device 400 includes a memory 410 and a processor 420. The memory 410 stores a program or an instruction executable by the processor 420. The program or the instruction, when executed by the processor 420, causes the processor 420 to implement operations of the detection method for the cross-misconnection of the photovoltaic connection terminals according to any one of the above embodiments. The electronic device 400 has the beneficial effects of any one of the above embodiments, which will not be elaborated herein.

In the present disclosure, the terms "first", "second", and "third" are only used for descriptive purposes, and cannot be understood as indicating or implying relative importance. "Plurality" means at least two, unless otherwise specifically defined. Terms such as "install", "connect", "connect to", "fix", and the like should be understood in a broad sense. For example, it may be a fixed connection or a detachable connection or connection as one piece; direct connection or indirect connection through an intermediate. For those of ordinary skill in the art, the specific meaning of the above-mentioned terms in the present disclosure can be understood according to specific circumstances.

In the description of the present disclosure, it should be understood that the orientation or the position indicated by terms such as "over", "below", "front", "rear", "left", and "right" should be construed to refer to the orientation or the position as shown in the drawings, and is only for the convenience of describing the present disclosure and simplifying the description, rather than indicating or implying that the pointed device or element must have a specific orientation, or be constructed and operated in a specific orientation, and therefore cannot be understood as a limitation of the present disclosure.

Reference throughout this specification to "one embodiment", "some embodiments", or "specific embodiments" means that a particular feature, structure, material, or characteristic described in connection with the embodiment or example is included in at least one embodiment or example of the present disclosure. The appearances of the above phrases in various places throughout this specification are not necessarily referring to the same embodiment or example. Further, the particular features, structures, materials, or characteristics may be combined in any suitable manner in one or more embodiments or examples.

Although preferred embodiments of the present disclosure are described above, the present disclosure is not limited to these embodiments. For those skilled in the art, various changes and variations can be made to the embodiments of the present disclosure. Any modification, equivalent replacement, improvement, etc. made within the spirit and principle of the present disclosure shall fall within the protection scope of the present disclosure.

## Claims

1. A detection method for cross-misconnection of photovoltaic connection terminals, the detection method being applied to an energy storage device, wherein:
the energy storage device comprises a first photovoltaic direct current (DC) converter and a second photovoltaic DC converter, wherein:
the first photovoltaic DC converter is provided with a first photovoltaic positive device terminal and a first photovoltaic negative device terminal, and comprises a first buck-boost inductor, the first photovoltaic positive device terminal being configured to be connected to a first panel positive terminal of a first photovoltaic panel; and
the second photovoltaic DC converter is provided with a second photovoltaic positive device terminal and a second photovoltaic negative device terminal, and comprises a second buck-boost inductor, the second photovoltaic positive device terminal being configured to be connected to a second panel positive terminal of a second photovoltaic panel; and
the detection method comprises:
acquiring a first converted inductor current and a first sampled inductor current, wherein the first converted inductor current is converted from a first input current of the first photovoltaic negative device terminal based on a first conversion relation, and the first sampled inductor current is an average current of the first buck-boost inductor within a sampling period;
acquiring a second converted inductor current, wherein the second converted inductor current is converted from a second input current of the second photovoltaic negative device terminal based on the first conversion relation; and
determining that a photovoltaic panel negative terminal cross-misconnection exists in response to determining that an absolute value of a difference between the first converted inductor current and the first sampled inductor current is greater than a first predetermined threshold and an absolute value of a difference between the second converted inductor current and the first sampled inductor current is less than a second predetermined threshold, wherein the photovoltaic panel negative terminal cross-misconnection means that a first panel negative terminal of the first photovoltaic panel is erroneously connected to the second photovoltaic negative device terminal, and a second panel negative terminal of the second photovoltaic panel is erroneously connected to the first photovoltaic negative device terminal.

2. The detection method for the cross-misconnection of the photovoltaic connection terminals according to claim 1, further comprising, subsequent to said determining that the photovoltaic panel negative terminal cross-misconnection exists:
transmitting cross-misconnection fault information to an energy storage management cloud platform, to enable the energy storage management cloud platform to transmit cross-misconnection prompt information to a user terminal based on the cross-misconnection fault information; or
transmitting the cross-misconnection fault information to the user terminal through short-range wireless communication.

3. The detection method for the cross-misconnection of the photovoltaic connection terminals according to claim 1 or 2, wherein the energy storage device further comprises a first indicator light and a second indicator light, wherein:
the first indicator light is disposed at the first photovoltaic negative device terminal and the second indicator light is disposed at the second photovoltaic negative device terminal; and
the detection method further comprises, subsequent to said determining that the photovoltaic panel negative terminal cross-misconnection exists: controlling the first indicator light and the second indicator light to light up or flash.

4. The detection method for the cross-misconnection of the photovoltaic connection terminals according to any one of claims 1 to 3, wherein the energy storage device further comprises a voice prompt module, wherein
the detection method further comprises, subsequent to said determining that the photovoltaic panel negative terminal cross-misconnection exists: controlling the voice prompt module to broadcast cross-misconnection fault information.

5. The detection method for the cross-misconnection of the photovoltaic connection terminals according to any one of claims 1 to 4, wherein the energy storage device further comprises a battery module, wherein
each of an output end of the first photovoltaic DC converter and an output end of the second photovoltaic DC converter is connected to the battery module; and
the detection method further comprises:
acquiring a first photovoltaic input voltage at an input end of the first photovoltaic DC converter, and a battery voltage of the battery module connected to the output end of the first photovoltaic DC converter;
determining a first bridge arm duty cycle of a bridge arm of the first photovoltaic DC converter that is adjacent to the first photovoltaic panel based on a ratio of the battery voltage to the first photovoltaic input voltage; and
determining the first conversion relation based on the first bridge arm duty cycle.

6. The detection method for the cross-misconnection of the photovoltaic connection terminals according to any one of claims 1 to 5, wherein said determining that the photovoltaic panel negative terminal cross-misconnection exists in response to determining that the absolute value of the difference between the first converted inductor current and the first sampled inductor current is greater than the first predetermined threshold, and the absolute value of the difference between the second converted inductor current and the first sampled inductor current is less than the second predetermined threshold comprises:
within a predetermined time duration, continuously acquiring the first converted inductor current and the first sampled inductor current, and continuously acquiring the second converted inductor current; and
in response to determining that the absolute value of the difference between the first converted inductor current and the first sampled inductor current remains greater than the first predetermined threshold throughout the predetermined time duration and the absolute value of the difference between the second converted inductor current and the first sampled inductor current remains less than the second predetermined threshold throughout the predetermined time duration, determining that the photovoltaic panel negative terminal cross-misconnection exists.

7. The detection method for the cross-misconnection of the photovoltaic connection terminals according to claim 6, wherein:
the first predetermined threshold ranges from 1 A to 3 A; and/or
the second predetermined threshold ranges from 1 A to 3 A; and/or
the predetermined time duration ranges from 1 s to 3 s.

8. The detection method for the cross-misconnection of the photovoltaic connection terminals according to claim 1, wherein:
a plurality of second photovoltaic DC converters are provided and a plurality of second photovoltaic panels are provided, the second photovoltaic positive device terminal of each of the plurality of second photovoltaic DC converters being configured to be connected to the second panel positive terminal of a corresponding one of the plurality of second photovoltaic panels;
said acquiring the second converted inductor current comprises: for each of the plurality of second photovoltaic DC converters, acquiring the second converted inductor current corresponding to the second photovoltaic DC converter; and
said determining that the photovoltaic panel negative terminal cross-misconnection exists in response to determining that the absolute value of the difference between the first converted inductor current and the first sampled inductor current is greater than the first predetermined threshold and the absolute value of the difference between the second converted inductor current and the first sampled inductor current is less than the second predetermined threshold comprises: taking each of the plurality of second photovoltaic DC converters as a current second photovoltaic DC converter in sequence; and in response to determining that the absolute value of the difference between the first converted inductor current and the first sampled inductor current is greater than the first predetermined threshold and an absolute value of a difference between the second converted inductor current corresponding to the current second photovoltaic DC converter and the first sampled inductor current is less than the second predetermined threshold, determining that the photovoltaic panel negative terminal cross-misconnection exists between the first photovoltaic DC converter and the current second photovoltaic DC converter.

9. The detection method for the cross-misconnection of the photovoltaic connection terminals according to any one of claims 1 to 8, wherein:
the first photovoltaic DC converter and the second photovoltaic DC converter share a common ground;
the first input current of the first photovoltaic negative device terminal is a current sampled at the first photovoltaic negative device terminal; and
the second input current of the second photovoltaic negative device terminal is a current sampled at the second photovoltaic negative device terminal.

10. The detection method for the cross-misconnection of the photovoltaic connection terminals according to claim 5, wherein the energy storage device includes a first voltage sensor and a second voltage sensor, the first voltage sensor being disposed between the first photovoltaic positive device terminal and the first photovoltaic negative device terminal of the first photovoltaic DC converter, the second voltage sensor being disposed across the battery module,
wherein said acquiring a first photovoltaic input voltage at an input end of the first photovoltaic DC converter, and a battery voltage of the battery module connected to the output end of the first photovoltaic DC converter comprises:
acquiring the first photovoltaic input voltage through the first voltage sensor; and
acquiring the battery voltage through the second voltage sensor.

11. The detection method for the cross-misconnection of the photovoltaic connection terminals according to claim 5 or 10, wherein said determining the first bridge arm duty cycle of a bridge arm of the first photovoltaic DC converter that is adjacent to the first photovoltaic panel based on the ratio of the battery voltage to the first photovoltaic input voltage comprises:
determining the first bridge arm duty cycle as a minimum value between 1 and the ratio of the battery voltage to the first photovoltaic input voltage.

12. The detection method for the cross-misconnection of the photovoltaic connection terminals according to any one of claims 1 to 11, wherein:
the first converted inductor current is obtained by multiplying the first input current of the first photovoltaic negative device terminal by the first conversion relation; and
the second converted inductor current is obtained by multiplying the second input current of the second photovoltaic negative device terminal by the first conversion relation.

13. The detection method for the cross-misconnection of the photovoltaic connection terminals according to any one of claims 2 to 4, wherein the cross-misconnection fault information includes position information of the cross-misconnection, a time point when the cross-misconnection occurs, and a time duration of the cross-misconnection.

14. The detection method for the cross-misconnection of the photovoltaic connection terminals according to any one of claims 1 to 13, further comprising:
acquiring a second sampled inductor current, wherein the second sampled inductor current is an average current of the second buck-boost inductor within the sampling period;
acquiring a third converted inductor current and a fourth converted inductor current, wherein the third converted inductor current is converted from the first input current of the first photovoltaic negative device terminal based on a second conversion relation, and the fourth converted inductor current is converted from the second input current of the second photovoltaic negative device terminal based on the second conversion relation, and the second conversion relation is determined based on a ratio of the battery voltage to a second photovoltaic input voltage at an input end of the second photovoltaic DC converter;
wherein said determining that a photovoltaic panel negative terminal cross-misconnection exists in response to determining that an absolute value of a difference between the first converted inductor current and the first sampled inductor current is greater than a first predetermined threshold and an absolute value of a difference between the second converted inductor current and the first sampled inductor current is less than a second predetermined threshold comprises:
determining that the photovoltaic panel negative terminal cross-misconnection exists when an absolute value of a difference between the first converted inductor current and the first sampled inductor current is greater than a first predetermined threshold, an absolute value of a difference between the second converted inductor current and the first sampled inductor current is less than a second predetermined threshold, an absolute value of a difference between the third converted inductor current and the second sampled inductor current is less than the second predetermined threshold, and an absolute value of a difference between the fourth converted inductor current and the second sampled inductor current is greater than the first predetermined threshold.

15. An electronic device, comprising a memory and a processor, wherein the memory stores a program or an instruction executable by the processor, and wherein the program or the instruction, when executed by the processor, causes the processor to implement operations of the detection method for the cross-misconnection of the photovoltaic connection terminals according to any one of claims 1 to 14.
